# FASCICULE DE BREVET EUROPEEN

(11) **EP 4 511 873 B1**
(45) Date de publication et mention de la délivrance du brevet: **13.05.2026**
(21) Numéro de dépôt: 23717959.3
(22) Date de dépôt: 12.04.2023
(51) Int. Cl.: H10P 10/00, H10P 90/00, H10W 10/10

(54) **PROCEDE D'ASSEMBLAGE DE DEUX SUBSTRATS PAR ADHESION MOLECULAIRE, ET STRUCTURE OBTENUE PAR UN TEL PROCEDE**
VERFAHREN ZUM ZUSAMMENFÜGEN VON ZWEI SUBSTRATEN DURCH MOLEKULARE HAFTUNG UND DURCH SOLCH EIN VERFAHREN ERHALTENE STRUKTUR
METHOD FOR ASSEMBLING TWO SUBSTRATES BY MOLECULAR ADHESION AND STRUCTURE OBTAINED BY SUCH A METHOD

(30) Priorité: 19.04.2022 FR 2203592
(43) Date de publication de la demande: 26.02.2025
(73) Titulaire: SOITEC, 38190 Bernin (FR)
(72) Inventeur: BROEKAART, Marcel, 38190 BERNIN (FR); LOGIOU, Morgane, 38190 BERNIN (FR)
(74) Mandataire: IP Trust
(86) Numéro de dépôt international: PCT/EP2023/059486
(87) Numéro de publication internationale: WO 2023/202917

(56) Documents cités:
- US-A- 5 407 506
- US-A1- 2006 216 904
- US-A1- 2008 171 443

## Description

L'invention trouve son application notamment dans les domaines de la microélectronique, des microsystèmes, de la photonique.

### ARRIERE PLAN TECHNOLOGIQUE DE L'INVENTION

L'adhésion moléculaire est un procédé d'assemblage de deux corps au cours duquel les faces ou surfaces principales de ces deux corps, parfaitement propres, planes et lisses, sont mises en contact intime l'une avec l'autre pour favoriser le développement de liaisons moléculaires, par exemple de type van der Waals ou covalentes. L'assemblage des deux corps est alors obtenu sans utilisation d'un adhésif. Ces liaisons peuvent être renforcées par l'application d'un traitement thermique à l'assemblage.

Ce procédé est utilisé en particulier pour la fabrication des substrats qui trouvent une application dans les domaines de la microélectronique, des microsystèmes, de la photonique... Dans ces domaines, les substrats présentent généralement la forme de plaquettes circulaires de matériaux qui peuvent être monocristallins, poly-cristallins ou amorphes, conducteurs, semi-conducteurs ou isolants.

Dans ces domaines et pour faciliter l'assemblage des substrats, il est usuel de former une couche diélectrique, typiquement d'oxyde de silicium, sur l'un et/ou l'autre de ces deux substrats, par dépôt, éventuellement suivi d'une étape de polissage, ou par simple oxydation lorsque le substrat est formé ou contient du silicium. Il est également usuel de préparer les faces principales pour les rendre propres (notamment en termes de particules et de contaminants) et lisses (pour fournir une rugosité de surface typiquement sous 0,5 nm en valeur quadratique moyenne sur un champ d'observation de 5 microns par 5 microns). Il est également parfois envisagé de rendre une au moins de ces faces réactives par l'application d'un plasma, typiquement d'oxygène ou d'azote. Cette préparation de surface vise à obtenir, directement après l'étape d'assemblage et avant tout recuit thermique, une énergie de collage maximale.

Après leur préparation, les deux substrats sont disposés l'un sur l'autre, au niveau de leurs faces principales. L'application d'une pression sur l'un ou l'autre des deux substrats provoque la mise en contact intime et ponctuel des faces principales, et la propagation de ce contact intime sur toute l'étendue des faces principales sous la forme d'une onde, dite « onde de collage ».

La littérature brevet, technique et scientifique regorge de documents exposant les principes et l'utilisation d'un tel procédé d'adhésion. On pourra notamment se référer à la publication de Rieutord et al., « Dynamics of a bonding front », Physical Review Letters, vol. 94, pp. 236101, 2005.

Un problème récurrent rencontré lors du déploiement d'un procédé d'adhésion moléculaire est l'apparition de défauts périphériques (souvent désigné « picots ») au niveau de l'interface de collage, aux lieux où l'onde de collage rencontre le bord des substrats. Lorsque l'onde est initiée sur un bord d'un substrat, ces défauts périphériques sont disposés sur un secteur périphérique généralement disposé sur le bord diamétralement opposé du point d'initiation de l'onde. Lorsque l'onde est initiée dans une zone centrale de l'un des substrats, ces défauts périphériques peuvent être disposés sur le contour entier. Ces défauts résultent du piégeage de gaz et/ou d'eau à l'interface de collage entre les deux substrats. Au niveau de ces défauts, les deux substrats ne sont pas en contact, et l'énergie d'adhésion locale est très faible, voire inexistante. Ces défauts, bien que présents, ne sont pas nécessairement visibles directement après la propagation de l'onde de collage, mais ils peuvent se révéler lors d'un recuit thermique de l'assemblage formé des deux substrats assemblés l'un à l'autre.

La vitesse de l'onde de collage a été identifiée comme étant un facteur influençant le nombre de tels défauts, et la réduction de cette vitesse conduit généralement à réduire le nombre de défauts, voire à les faire disparaitre. A cet effet, différentes techniques de contrôle de cette vitesse ont été proposées, notamment via un traitement de l'état de surface de l'un et/ou l'autre des substrats, en particulier par chauffage (WO2007060145). Il a également été proposé, en vue de réduire la vitesse de l'onde de collage, de projeter, au moment du collage, un jet gazeux, éventuellement chaud, en direction du point d'initiation de l'onde de collage. Toutefois, ces traitements, s'ils peuvent effectivement induire une réduction de la vitesse de collage, sont susceptibles de réduire également l'énergie d'adhésion, ce qui peut être préjudiciable pour certaines applications. Le document WO2013160841 prévoit quant à lui de maintenir les substrats, lors de la propagation de l'onde, dans une atmosphère de gaz présentant, à la température et à la pression de ladite atmosphère, un coefficient de Joule-Thomson négatif, par exemple de l'hélium, du néon ou de l'hydrogène.

En outre, les documents US 2006216904 A1, US 5407506 A et US 2008171443 A1 divulguent des procédés décrivant un traitement de surface de la couche de liaison intermédiaire avant l'étape de liaison.

Quel que soit la solution retenue dans l'état de la technique et quelle que soit l'efficacité de cette solution, elle forme une contrainte importante.

### OBJET DE L'INVENTION

Un but de l'invention est de proposer un procédé d'assemblage par adhésion moléculaire qui se distingue de cet état de la technique et qui permet de prévenir, ou pour le moins de limiter, l'apparition des défauts de type « picots ». Plus spécifiquement, un but de l'invention est de proposer un procédé d'assemblage par adhésion moléculaire qui puisse fournir une énergie de collage importante avec un nombre de défauts de type « picots » bien moindre que dans les procédés de l'état de la technique, et sans imposer les contraintes de l'état de la technique.

### BREVE DESCRIPTION DE L'INVENTION

En vue de la réalisation de ce but, l'objet de l'invention propose un procédé d'assemblage par adhésion moléculaire de deux substrats présentant chacun une face principale, l'un au moins des deux substrats étant pourvu d'une couche superficielle diélectrique du côté de sa face principale. Le procédé comprend les étapes suivantes:
a. la mise en contact des faces principales des deux substrats, puis ;
b. l'initiation et la propagation d'une onde de collage entre les faces principales des deux substrats pour les assembler l'un à l'autre.

Le procédé est remarquable en ce qu'il comprend, avant l'étape de mise en contact, une étape de préparation de la couche superficielle diélectrique visant à introduire, dans cette couche, une dose de soufre supérieure à 3,0 E13 at/cm^2.

De manière surprenante, l'introduction de soufre dans la couche superficielle et avec une telle dose, permet de prévenir, ou pour le moins limiter, l'apparition de défauts de type picots, même lorsque les deux substrats sont assemblés avec une énergie de collage importante.

Selon d'autres caractéristiques avantageuses et non limitatives de l'invention, prises seules ou selon toute combinaison techniquement réalisable :
- la dose introduite de soufre est supérieure à 3,5 E13 at/cm^2 ;
- l'étape de préparation de la couche superficielle diélectrique vise également à introduire dans cette couche une dose de fluor supérieure à 4,0 E14 at/cm^2 ;
- l'étape de préparation comprend l'activation de la couche superficielle diélectrique par un plasma d'un gaz comprenant du soufre ;
- l'étape de préparation comprend l'activation de la couche superficielle diélectrique par un plasma comprenant de l'hexafluorure de soufre ;
- le plasma comprend également de l'oxygène ou de l'azote ;
- l'activation de la couche superficielle est conduite pendant une durée d'activation comprise entre 15 secondes et 2 minutes ;
- la couche superficielle est exposée au plasma d'oxygène ou d'azote pendant toute la durée de l'activation, et une quantité maitrisée d'hexafluorure de soufre est mélangée à l'oxygène ou à l'azote pendant une période déterminée de la durée d'activation ;
- la période déterminée est respectivement précédée et suivie de périodes pendant laquelle la couche superficielle diélectrique est exposée au plasma formé d'un gaz d'activation d'oxygène ou d'azote ;
- l'étape de préparation comprend la préparation d'une chambre d'un équipement d'activation plasma par un plasma d'un gaz comprenant du soufre puis, après la préparation de la chambre, le traitement de la couche superficielle diélectrique dans la chambre par un plasma comprenant de l'oxygène ou de l'azote;
- l'étape de préparation comprend la préparation d'une chambre d'un équipement d'activation plasma par un plasma comprenant de l'hexafluorure de soufre puis, après la préparation de la chambre, le traitement de la couche superficielle diélectrique dans la chambre par un plasma comprenant de l'oxygène ou de l'azote.
- le procédé d'assemblage comprend le traitement thermique des deux substrats assemblés l'un à l'autre ;
- les deux substrats sont pourvus d'une couche superficielle diélectrique d'oxyde de silicium ou de nitrure de silicium du côté de leur face principale, et l'étape de préparation est conduite sur chacune des couches superficielles diélectriques ;
- la couche superficielle diélectrique est en oxyde de silicium ;
- l'oxyde de silicium de la couche superficielle diélectrique incorpore de l'azote, préférentiellement dans un ratio azote/oxygène inférieur à 0,5 ;
- la couche superficielle diélectrique est en nitrure de silicium ;
- le procédé d'assemblage comprend une étape de nettoyage d'une au moins des faces principales des deux substrats, entre l'étape de préparation et l'étape de mise en contact.

Selon un autre aspect, l'invention propose une structure comprenant un substrat support, une couche enterrée diélectrique disposée sur et en contact avec le substrat support, et une couche dite « utile » sur et en contact avec la couche enterrée.

Selon l'invention, la couche enterrée diélectrique comporte une dose de soufre supérieure à 3,0 E13 at/cm^2.

Selon d'autres caractéristiques avantageuses et non limitatives de l'invention, prises seules ou selon toute combinaison techniquement réalisable :
- la dose de soufre est supérieure à 3,5 E13 at/cm^2;
- la couche enterrée diélectrique comporte une dose de fluor supérieure à 4,0 E14 at/cm^2 ;
- la couche enterrée diélectrique est en oxyde de silicium ;
- l'oxyde de silicium de la couche enterrée diélectrique incorpore de l'azote, préférentiellement dans un ratio azote/oxygène inférieur à 0,5 ;
- la couche enterrée diélectrique est en nitrure de silicium.

### BREVE DESCRIPTION DES FIGURES

D'autres caractéristiques et avantages de l'invention ressortiront de la description détaillée de l'invention qui va suivre en référence aux figures annexées sur lesquels :
[Fig.1a]
   [Fig.1b]

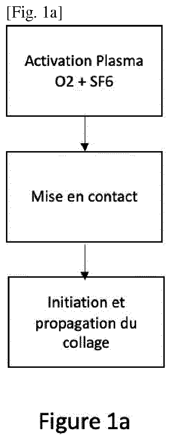

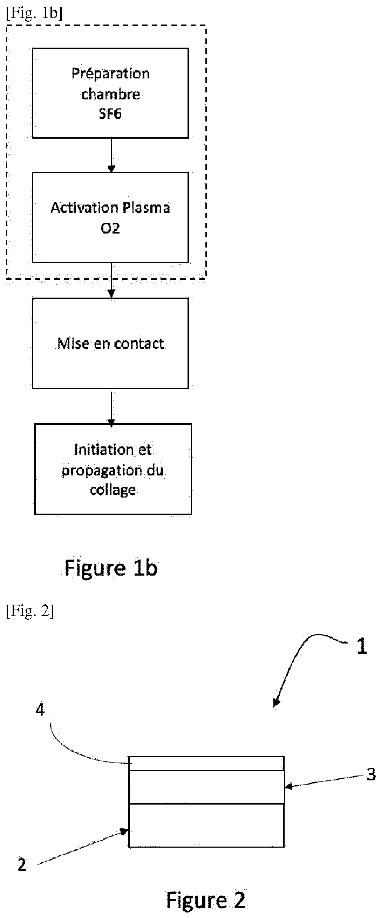

   Les figures 1a et 1b représentent deux exemples de procédé d'assemblage conforme à l'invention ;
[Fig.2]
   La [Fig.2] représente une structure pouvant être obtenue à l'aide d'un procédé conforme à l'invention.

### DESCRIPTION DETAILLEE DE L'INVENTION

La présente invention porte sur un procédé d'assemblage de deux substrats par adhésion moléculaire.

Les deux substrats peuvent être de nature quelconque, isolante (tel que du quartz, du verre, ou un matériau piézoélectrique), conductrice (un métal) ou semi-conducteur (comme du silicium, du nitrure de gallium, du carbure de silicium), dans toutes leurs formes disponibles : monocristalline, polycristalline ou amorphe. Les deux substrats peuvent chacun combiner des matériaux de natures différentes. Par exemple, un des deux substrats peut être formé d'une couche piézoélectrique reportée directement ou par l'intermédiaire d'une couche intermédiaire, par exemple un adhésif, sur un support en silicium. Les deux substrats peuvent être de même nature ou de natures différentes. Ils peuvent notamment présenter un coefficient de dilatation thermique différent l'un de l'autre, ce qui limite la température à laquelle l'assemblage peut être exposé, notamment pour renforcer l'énergie de liaison entre les deux substrats. Les substrats peuvent se présenter sous la forme de plaquettes circulaires, présentant un diamètre normalisé de 150, 200, ou 300mm comme cela est généralement le cas dans le domaine de la microélectronique, mais l'invention n'est nullement limitée à l'assemblage de deux plaquettes circulaires ou présentant une dimension normalisée.

Quelle que soit la nature et la forme des deux substrats, ceux-ci sont destinés à être assemblés l'un à l'autre par l'intermédiaire de leurs faces dites « principales ».

Pour faciliter cet assemblage, on a muni l'un au moins des deux substrats, du côté de sa face principale, d'une couche diélectrique, par exemple en oxyde de silicium ou en nitrure de silicium. Cette couche superficielle diélectrique constitue donc la surface d'assemblage. Elle peut être d'une épaisseur quelconque, typiquement comprise entre quelques nm et quelques microns, par exemple entre 1 nm et 5 microns. Dans certains cas, les deux substrats peuvent être munis d'une telle couche superficielle diélectrique.

Par « couche d'oxyde de silicium », on désigne une couche mince principalement constituée d'oxyde de silicium. D'autres éléments chimiques peuvent également y être incorporés, sous forme de traces ou dans des concentrations plus importantes, comme cela sera exposé dans la suite de cette description. Cette couche peut notamment incorporer de l'azote (pour former une couche de SiON), par exemple dans un dans un ratio azote/oxygène inférieur à 0,5. Pour caractériser la proportion d'azote dans la couche, on pourra s'appuyer sur une mesure de son indice de réfraction qui évolue (à une longueur d'onde de 620nm) entre 1,44 pour du SiO2 à 2,35 pour du Si3N4. La couche superficielle diélectrique peut donc être formée de SiO₁₋ₓNₓ, la proportion x d'azote dans la couche pouvant être comprise de 0 à 1.

La ou les couches superficielles diélectriques peuvent être formées par toute technique qui convient. Lorsque le substrat comprend du silicium, une couche superficielle diélectrique d'oxyde de silicium peut être formée par oxydation, sèche ou humide. Plus généralement, cette couche superficielle diélectrique peut être formée par dépôt. A titre d'exemple, il peut s'agir d'une technique de dépôt LPCVD (acronyme de l'expression anglo-saxonne « Low Pressure Chemical Vapor Deposition » ou dépôt chimique en phase vapeur à pression sous atmosphérique) ou PECVD (acronyme de l'expression anglo-saxonne « Plasma Enhanced Chemical Vapor Deposition » ou dépôt chimique en phase vapeur assisté par plasma). Il peut encore s'agir d'une technique de dépôt par centrifugation, désignée « spin on glass » selon le vocable anglo-saxon employé dans le domaine. La couche diélectrique déposée peut être polie, pour réduire sa rugosité et la rendre compatible avec le procédé d'assemblage, typiquement sous une valeur de 0,7 nm en valeur quadratique moyenne sur un champ d'observation de 5 microns par 5 microns.

D'une manière plus générale, on prépare les surfaces exposées des faces principales au cours d'une étape préliminaire de préparation des deux substrats pour les rendre propres (notamment en termes de particules et de contaminants) et lisses (pour fournir une rugosité de surface inférieure à la valeur précitée). A cet effet, un procédé conforme à l'invention peut comprendre des étapes préalables de nettoyage et/ou de polissage des substrats, bien connues en soi, pour conditionner ces deux substrats aux étapes suivantes d'assemblage. L'étape de nettoyage peut notamment comprendre le brossage des faces principales tout en déversant sur ces surfaces un liquide, tel que de l'eau déionisée.

Comme cela a été rappelé en introduction de cette demande, ces étapes d'assemblage comprennent :
a. la mise en contact des deux substrats par leurs faces principales, puis ;
b. l'initiation et la propagation d'une onde de collage entre les deux substrats pour les assembler l'un à l'autre.

A titre d'illustration uniquement, ces étapes d'assemblage peuvent être conduites sur un équipement de collage automatique. Dans un tel cas, un premier substrat est manipulé par le bras d'un système de manutention de l'équipement pour le disposer sur un support plan de sorte à exposer sa face principale. Le second substrat est ensuite manipulé par le bras du système de manutention pour le disposer en contact, du côté de sa face principale, avec le premier substrat. Un actionneur de l'équipement est déplacé pour appliquer une pression modérée de quelques Newtons sur la surface exposée du second substrat pour provoquer la mise en contact intime entre le premier substrat et le second, l'initiation et la propagation de l'onde de collage. Cette pression peut être appliquée en tout endroit, notamment sur une portion périphérique ou sur une portion centrale de la face exposée du second substrat.

Dans tous les cas et quelle que soit la manière avec laquelle cette onde a été initiée, l'onde de collage se propage à partir du lieu d'initiation vers la portion périphérique de l'assemblage de manière à mettre en contact intime les deux substrats sur toute l'étendue de leurs faces principales. La propagation de l'onde n'est pas instantanée et cette propagation peut se dérouler pendant plusieurs secondes, selon bien entendu la dimension des substrats.

Il est usuel également de prévoir une étape de préparation de la couche superficielle diélectrique (ou des couches superficielles diélectrique lorsque les deux substrats sont munis d'une telle couche) par activation plasma, typiquement un plasma d'oxygène ou d'azote. Cette étape de préparation peut consister à placer le substrat dans une chambre d'un équipement d'activation plasma, par exemple sur un support plan disposé dans la chambre, de manière à exposer la couche superficielle au plasma préparé par une source. Un flux d'oxygène ou d'azote est introduit dans la source plasma de l'équipement avec un débit maitrisé et un plasma de ce gaz est généré, par exemple par l'intermédiaire de champs magnétiques ou électriques variables. Les espèces du plasma sont projetées sur la couche superficielle diélectrique pour activer la face du substrat. Ces opérations peuvent être opérées à pression atmosphérique ou sous-atmosphérique. Cette activation permet généralement d'augmenter l'énergie de collage entre les deux substrats directement après l'assemblage ou après l'application d'un traitement thermique de renforcement.

La demanderesse a ainsi mené des expériences préliminaires visant à étudier l'effet de l'activation plasma d'une couche superficielle en oxyde de silicium sur la qualité d'un assemblage obtenu par adhésion moléculaire, dont on vient de faire la description détaillée. Plus particulièrement, ces expériences préliminaires visaient à évaluer l'intérêt d'une activation plasma lorsque ce plasma incorpore de l'hexafluorure de soufre (SF6). Un résumé des résultats obtenus est présenté dans le tableau ci-dessous.

| Réf | Débit O2 (sccm) | Débit SF6 (sccm) | Durée SF6 (s) | Dose F SIMS (at/cm²) | Dose S TXRF (at/cm²) | Energie de collage anhydre (mJ/m^2) | Durée de l'onde (s) | Picot |
|---|---|---|---|---|---|---|---|---|
| 1 | 75 | 0 | 0 | 3,0^{E}+13 | 2,4^{E}+12 | 1905 | 6 | Oui |
| 2 | 75 | 1 | 7 | - | - | - | - | Oui |
| 3 | 75 | 3 | 3 | - | - | 2859 | 10 | Oui |
| 4 | 75 | 5 | 5 | 5,3^{E}+14 | 3,54^{E}+13 | 2190 | 12 | Non |
| 5 | 75 | 3+5 | 3+5 | - | - | - | 12,5 | Non |
| 6 | 75 | 3 | 20 | 4,3^{E}+14 | 7,73^{E}+13 | 2530 | 11,5 | Non |
| 7 | 75 | | | 8,9^{E}+14 | 4,74^{E}+12 | 2463 | 7 | Oui |
| 8 | 75 | | | 8,9^{E}+14 | 5,09^{E}+12 | 2599 | 6 | Oui |
| 9 | 75 | | | 6,2^{E}+14 | 4,48^{E}+12 | 2306 | 9,5 | Oui |
| 10 | 75 | | | 8,7^{E}+14 | 3,18^{E}+13 | 2300 | 12 | Non |

Lors de ces expériences préliminaires, les substrats étaient constitués de paires de plaquettes de 150 mm en tantalate de lithium et en silicium, chacune munie d'une couche superficielle d'oxyde de silicium (sans azote) de respectivement 30nm et 650nm déposés par PECVD. L'activation plasma a été conduite pendant une durée d'activation de 30 secondes, à une puissance de 150W, sur chacune des deux couches superficielles, avant de les assembler selon le procédé d'assemblage par adhésion moléculaire qui vient d'être présenté. L'énergie de collage a été mesurée après un traitement thermique de renforcement à 180°C pendant 60 min, par une méthode d'insertion de lame (ou « double cantilever beam » selon l'expression anlgo-saxonne parfois employée). Les expériences reportées dans le tableau ont toutes été conduites sur un même équipement plasma de type CCP (« Capacitively Coupled Plasma » ou plasma par couplage capacitif) sauf l'expérience 10 conduite sur un équipement de type ICP (« Inductive Coupled Plasma » ou plasma par couplage inductif).

### Expérience de référence

L'expérience 1 du tableau forme l'expérience de référence correspondant à une activation de la couche superficielle avec un plasma d'oxygène seul. Le débit d'oxygène pendant cette activation (et lors de toutes les expériences rapportées dans ce tableau) a été fixé à 75 SCCM. L'énergie de collage a été mesurée à 1905 mJ/m^2, l'onde de collage s'est propagée pendant une durée de 6 secondes, et l'assemblage présentait un niveau de défectivité de type picots notable. L'analyse de la couche superficielle en oxyde de silicium respectivement en SIMS et en TXRF a révélé une dose de fluor incorporée de 3,0 E+13 at/cm^2 et soufre de 2,4^{E}+12 at/cm^2, ce qui correspond à des traces de ces éléments.

### Expériences 2 à 6

Dans ces expériences, on a introduit une quantité maitrisée de SF6 au cours de l'activation plasma à base d'oxygène, cette quantité maitrisée étant croissante pour les expériences 2 à 6. La quantité maitrisée de SF6 est obtenue en modulant le débit et la durée de ce flux. Celui-ci a été introduit soit en début d'activation plasma, soit au milieu de cette activation, cette dernière alternative étant préférée, car le plasma de la source est plus stable et les phénomènes mieux contrôlés. On observe qu'une dose notable de soufre et de fluor a été intégrée dans les couches superficielles au cours des activations réalisées lors des expériences 2 à 6. Dans l'expérience 5, la quantité maitrisée de SF6 a été introduite au cours de deux séquences, la première conduisant à introduire 3 SCCM de SF6 pendant 3 secondes, puis après une interruption de ce flux, une séquence de 5 SCCM de SF6 pendant 5 secondes.

On rappelle que l'unité de mesure SCCM (« Standard Cubic Centimeters per Minute » ou « centimètre cube standard par minute ») est une unité physique de débit massique d'un gaz, en cm³/min, à une densité définie par des conditions standards de température et de pression.

### Expériences 7 à 10

Dans ces expériences, on a alimenté la source de l'équipement plasma activé à 2000W, d'un mélange gazeux comprenant environ 20% de SF6 (10 SCCM) dans 80% d'oxygène (50 SCCM) dans une étape préliminaire et sans qu'un des substrats de l'expérience ne soit placé dans cet équipement. Cette étape préliminaire visait à préparer la chambre de l'équipement d'activation plasma afin de recouvrir la surface interne de cette chambre d'espèces comprenant du soufre et du fluor. Puis, les expériences ont été menées en traitant les couches superficielles d'oxyde de silicium des substrats par une activation plasma conventionnelle à base d'oxygène seul dans la chambre ainsi préparée. Les espèces soufrées et/ou fluorées recouvrant la surface interne de la chambre ont été arrachées de ces surfaces pendant l'activation plasma d'oxygène et intégrées dans ce plasma pendant toute la durée de l'activation.

Comparativement à l'expérience 1 de référence, on observe que toutes les autres expériences menées ont conduit à accroitre l'énergie de collage mesurée de manière significative. Cet effet du fluor, qui a été déjà rapporté par ailleurs, semble être provoqué par l'incorporation de fluor dans la couche superficielle avec une dose supérieure à 4,0 E14 at/cm^2.

De manière plus surprenante, ces résultats montrent que la vitesse de l'onde de collage est affectée par la dose de soufre incorporée dans la couche superficielle diélectrique : plus cette dose est importante, plus cette vitesse est réduite. Cet effet est obtenu sans affecter de manière significative l'énergie de collage, et dans tous les cas celle-ci reste supérieure à l'énergie de collage de l'expérience de référence. Il semble donc possible de maitriser la vitesse de cette onde en contrôlant la dose de soufre introduit dans la couche superficielle diélectrique.

Lorsque cette dose de soufre est suffisante, supérieure à 3,0 E13 at/cm^2, et préférentiellement supérieure à 3,5 E13 at/cm^2, cette vitesse d'onde est suffisamment faible pour que les défauts de type picots ne soient plus présents de manière notable, comme cela est révélé sur les expériences 4, 5. 6 et 10.

D'autres expériences ont permis de reproduire ces résultats pour des couches superficielles diélectriques autre que celles, en oxyde de silicium (SiO2), qui ont fait l'objet des expériences reportées dans le tableau. En particulier, des résultats similaires ont été obtenus lorsque la couche superficielle diélectrique était formée d'oxyde de silicium comportant un ratio azote/oxygène strictement supérieur à 0, et lorsque cette couche superficielle diélectrique était formée de nitrure de silicium.

La demanderesse a tiré profit de ces expériences et de ces observations pour proposer un procédé d'assemblage par adhésion moléculaire de deux substrats permettant de prévenir, ou pour le moins de limiter, l'apparition de défaut de collage de type picots. De plus, ce bénéfice peut être obtenu sans affecter l'énergie de collage de l'assemblage, voire même en fournissant une énergie de collage significativement améliorée.

Dans la séquence formée des étapes de mise en contact des faces principales des deux substrats, d'initiation et de propagation d'une onde de collage qui ont été présentés précédemment, un procédé conforme à l'invention prévoit donc, avant l'étape de mise en contact, une étape de préparation de la couche superficielle diélectrique visant à introduire dans cette couche une dose de soufre supérieure à 3,0 E13 at/cm^2. Avantageusement, cette dose est supérieure à 3,5 E13 at/cm^2. Cette dose peut être mesurée par mesure TXRF ou par mesure SIMS, comme cela a été le cas dans les expériences rapportées.

Avantageusement, cette dose correspond à celle présente dans une épaisseur d'au plus 10 nm, voire même 7,5 nm directement sous la face principale du substrat, car il est probable que seule cette épaisseur peut affecter les caractéristiques du collage.

Pour également bénéficier d'une énergie de collage améliorée, en limitant l'apparition de défauts de type picots, on pourra également rechercher à introduire dans la couche superficielle diélectrique une dose de fluor supérieure à 4,0 E14 at/cm^2. Avantageusement ici aussi, cette dose correspond à celle présente dans une épaisseur d'au plus 10 nm, voire même 7,5 nm directement sous la face principale du substrat, car il est probable que seule cette épaisseur peut affecter les caractéristiques du collage. Cette dose peut être mesurée par mesure TXRF ou par mesure SIMS

Une première approche permettant d'introduire le soufre avec une dose cible peut consister à activer par plasma la couche superficielle diélectrique, par l'intermédiaire du plasma d'un gaz comprenant du soufre, tel que l'hexafluorure de soufre. Cette approche fait l'objet de la [Fig.1a].

Ce gaz comprenant du soufre, par exemple l'hexafluorure de soufre, peut être mélangé à un gaz d'activation constitué par exemple d'oxygène ou d'azote. Ce mélange est dosé de sorte que, à l'issue de l'étape d'activation plasma, la dose cible de soufre (et éventuellement de fluor) soit bien atteinte ou dépassée.

La durée d'une telle activation plasma est typiquement comprise entre 15 secondes et deux minutes. Plus précisément, la durée d'activation est celle séparant l'instant d'allumage du plasma dans la source de l'équipement à son extinction. Pendant cette durée, la couche superficielle diélectrique est exposée au plasma formé d'un gaz d'activation d'oxygène ou d'azote.

Le gaz comprenant du soufre peut-être introduit avec un débit maitrisé pendant toute cette durée, ou pendant une partie de cette durée uniquement, pour se mélanger à l'oxygène ou à l'azote pendant une période déterminée de la durée d'activation. De préférence, cette période déterminée n'inclut pas le moment d'allumage du plasma, car cet allumage peut conduire à introduire les espèces soufrées et/ou fluorées du plasma dans la couche superficielle de manière non répétable, ce qui ne permet pas de maitriser parfaitement les doses introduites, ce qui peut être dommageable pour la bonne maitrise du procédé, notamment lorsque les doses visées de soufre et, éventuellement, de fluor sont proches des doses limites. Avantageusement donc, la période déterminée pendant laquelle la couche superficielle diélectrique est exposée au plasma formé d'un gaz contenant du souffre est respectivement précédée et suivi de périodes pendant laquelle la couche superficielle diélectrique est exposée au plasma formé d'un gaz d'activation d'oxygène ou d'azote.

Pour compléter la description de la [Fig.1a], l'étape de préparation de la couche superficielle diélectrique visant à introduire dans cette couche une dose de soufre supérieure à 3,0 E13 at/cm^2, est suivie de l'étape de mise en contact des faces principales des deux substrats, puis de l'étape d'initiation et de propagation d'une onde de collage entre les faces principales des deux substrats pour les assembler l'un à l'autre.

Comme on l'a énoncé dans une partie précédente, on peut prévoir une étape de nettoyage de la face principale du substrat, entre l'étape de préparation et l'étape de mise en contact. Cette étape de nettoyage peut correspondre ou comprendre le brossage de cette face tout en y déversant un liquide, tel que de l'eau déminéralisée. Avantageusement l'étape de nettoyage est appliquée aux faces principales des deux substrats, directement avant leur assemblage.

Selon une autre approche, représentée sur la [Fig.1b], l'étape de préparation comprend la préparation de la chambre de l'équipement d'activation plasma à l'aide d'un plasma d'un gaz comprenant du soufre puis, après la préparation de la chambre, le traitement de la couche superficielle diélectrique de l'un au moins des substrats, dans la chambre, par un plasma comprenant de l'oxygène ou de l'azote.

Comme on l'a déjà présenté, l'activation plasma à l'aide d'un plasma d'un gaz comprenant du soufre est réalisée alors que le substrat à préparer n'est pas présent dans la chambre. Le gaz comprenant du soufre peut être de l'hexafluorure de soufre mélangé avec un gaz d'activation tel que de l'oxygène ou de l'azote. Cette sous-étape vise à recouvrir la surface interne de la chambre d'espèces soufrées et, éventuellement fluorées, ces espèces étant alors arrachées de la surface interne lors de l'activation plasma de la couche superficielle diélectrique menée dans la sous-étape suivante de l'étape de préparation. On ajustera les paramètres (notamment le débit du gaz soufré, la durée du plasma et sa puissance) pour faire en sorte que suffisamment d'espèces soient générées et incorporées, au cours de la sous-étape suivante d'activation plasma, dans la couche superficielle.

Pour compléter la description de la [Fig.1b], l'étape de préparation de la couche superficielle diélectrique selon cette approche, est également suivie de l'étape de mise en contact des faces principales des deux substrats, puis de l'étape d'initiation et de propagation d'une onde de collage entre les faces principales des deux substrats pour les assembler l'un à l'autre. On peut également prévoir l'étape de nettoyage décrite dans le cadre de la description de l'approche précédente.

La couche superficielle diélectrique est avantageusement une couche d'oxyde de silicium, pouvant incorporer de l'azote dans toute proportion souhaitée, ou du nitrure de silicium.

Avant, pendant ou à l'issue des étapes du procédé d'assemblage qui vient d'être décrit, il est naturellement possible d'appliquer d'autres étapes aux substrats, notamment celles d'un procédé de fabrication d'une structure obtenue par assemblage de deux substrats par adhésion moléculaire.

On peut notamment prévoir d'appliquer un traitement thermique de renforcement de l'assemblage, des étapes de réduction d'épaisseur de l'un au moins des deux substrats de manière à en former une couche. Cette réduction d'épaisseur peut être réalisée par amincissement du substrat (par exemple par meulage) ou par fracture. Dans ce cas, on a pu prévoir d'introduire dans le substrat à fracturer, et typiquement avant l'étape de mise en contact du procédé d'assemblage, des espèces légères visant à former un plan fragile de fracture dans le substrat dont on souhaite réduire l'épaisseur.

Dans cette application ou le procédé d'assemblage s'insère dans un procédé de report d'une couche, on dispose à l'issue de ce procédé et en référence à la [Fig.2] d'une structure 1 comprenant un substrat support 2, une couche enterrée diélectrique 3, avantageusement une couche d'oxyde de silicium ou de nitrure de silicium, sur et en contact avec le substrat support 2 et une couche dite « utile » 4 sur et en contact avec la couche enterrée 3.

La couche enterrée présente une interface de collage, correspondant à son interface avec le substrat support 2, à son interface avec la couche utile 4 ou incorporée dans son épaisseur, selon que le procédé ait mis en œuvre une unique couche superficielle diélectrique disposée sur l'un ou l'autre des substrats ou deux de ces couches disposées sur chacune des faces principales des substrats.

Cette couche enterrée diélectrique 3 comprend une dose de soufre supérieure à 3,0 E13 at/cm^2, et avantageusement supérieure à 3,5 E13 at/cm^2. Elle peut présenter une dose de fluor supérieure à 4,0 E14 at/cm^2. Comme on l'a dit précédemment, lorsque la couche enterrée diélectrique est en oxyde de silicium, elle peut incorporer d'autres espèces, notamment d'azote. Avantageusement, ces doses correspondent à celles présentes dans une épaisseur d'au plus 10 nm d'un côté et/ou de l'autre de l'interface de collage.

Bien entendu l'invention n'est pas limitée aux modes de mise en œuvre décrits et on peut y apporter des variantes de réalisation sans sortir du cadre de l'invention tel que défini par les revendications.

Bien que l'on ait pris ici l'hexafluorure de soufre en exemple comme gaz comprenant du soufre (et du fluor), l'invention n'est nullement limitée à l'utilisation de ce gaz. On peut notamment prévoir d'utiliser en remplacement tout gaz soufré tel que du Fluorure de sulfuryle (SO2F2) ou du Tétrafluorure de thionyle (SO2F4).

L'étape de préparation conforme à l'invention peut s'appliquer à une unique couche superficielle diélectrique formé sur l'un des substrats, même si les deux substrats comportent une telle couche superficielle diélectrique. L'étape de préparation peut également s'appliquer à chacun des substrats, et dans ce cas chacun est muni d'une couche superficielle diélectrique.

Enfin, dans une alternative non détaillée, les espèces de soufre et, éventuellement, de fluor peuvent être incorporées dans la couche superficielle diélectrique lors de sa formation, par exemple lors de l'oxydation ou nitruration d'un substrat comprenant du silicium, ou lors de son dépôt.

## Revendications

1. Procédé d'assemblage par adhésion moléculaire de deux substrats présentant chacun une face principale, l'un au moins des deux substrats étant pourvu d'une couche superficielle diélectrique du côté de sa face principale, le procédé comprenant les étapes suivantes :
(a) la mise en contact des faces principales des deux substrats, puis ;
(b) l'initiation et la propagation d'une onde de collage entre les faces principales des deux substrats pour les assembler l'un à l'autre ;
le procédé étant **caractérisé en ce qu'**il comprend, avant l'étape de mise en contact, une étape de préparation de la couche superficielle diélectrique visant à introduire dans cette couche une dose de soufre supérieure à 3,0 E13 at/cm^2.

2. Procédé d'assemblage selon la revendication précédente dans lequel la dose de soufre est supérieure à 3,5 E13 at/cm^2.

3. Procédé d'assemblage selon l'une des revendications précédentes dans lequel l'étape de préparation de la couche superficielle diélectrique vise également à introduire dans cette couche une dose de fluor supérieure à 4,0 E14 at/cm^2.

4. Procédé d'assemblage selon l'une des revendications 1 et 2 dans lequel l'étape de préparation comprend l'activation de la couche superficielle diélectrique par un plasma d'un gaz comprenant du soufre, tel qu'un plasma comprenant de l'hexafluorure de soufre.

5. Procédé d'assemblage selon la revendication précédente dans lequel le plasma comprend également de l'oxygène ou de l'azote.

6. Procédé d'assemblage selon la revendication précédente dans lequel l'activation de la couche superficielle diélectrique est conduite pendant une durée d'activation comprise entre 15 secondes et 2 minutes.

7. Procédé d'assemblage selon la revendication précédente dans lequel la couche superficielle est exposée au plasma d'oxygène ou d'azote pendant toute la durée de l'activation, et une quantité maitrisée d'hexafluorure de soufre est mélangée à l'oxygène ou à l'azote pendant une période déterminée de la durée d'activation.

8. Procédé d'assemblage selon la revendication précédente dans lequel la période déterminée est respectivement précédée et suivie de périodes pendant laquelle la couche superficielle diélectrique est exposée au plasma formé d'un gaz d'activation d'oxygène ou d'azote.

9. Procédé d'assemblage selon l'une des revendications 1 à 2 dans lequel l'étape de préparation comprend la préparation d'une chambre d'un équipement d'activation plasma par un plasma d'un gaz comprenant du soufre puis, après la préparation de la chambre, le traitement de la couche superficielle diélectrique dans la chambre par un plasma comprenant de l'oxygène ou de l'azote.

10. Procédé d'assemblage selon l'une des revendications précédentes comprenant le traitement thermique des deux substrats assemblés l'un à l'autre.

11. Procédé d'assemblage selon l'une des revendications précédentes dans lequel les deux substrats sont pourvus d'une couche superficielle diélectrique d'oxyde de silicium ou de nitrure de silicium du côté de leur face principale, et l'étape de préparation est conduite sur chacune des couches superficielles diélectriques.

12. Procédé d'assemblage selon l'une des revendications précédentes dans lequel la couche superficielle diélectrique est en oxyde de silicium.

13. Procédé d'assemblage selon l'une des revendications précédentes comprenant une étape de nettoyage d'une au moins des faces principales des deux substrats, entre l'étape de préparation et l'étape de mise en contact.

14. Structure (1) comprenant un substrat support (2), une couche enterrée diélectrique (3) disposée sur et en contact avec le substrat support (2) et une couche dite « utile » (4) sur et en contact avec la couche enterrée (3), la structure étant **caractérisée en ce que** la couche enterrée diélectrique (3) comporte une dose de soufre supérieure à 3,0 E13 at/ cm^2.

15. Structure (1) selon la revendication précédente dans laquelle la dose de soufre est supérieure à 3,5 E13 at/cm^2.

16. Structure (1) selon la revendication précédente dans laquelle la couche enterrée diélectrique (3) comporte une dose de fluor supérieure à 4,0 E14 at/cm^2.

17. Structure (1) selon l'une des revendications 14 à 16 dans laquelle la couche enterrée diélectrique est en oxyde de silicium.

## Patentansprüche

1. Verfahren zum Zusammenfügen durch molekulare Adhäsion von zwei Substraten, die jeweils eine Hauptfläche aufweisen, wobei mindestens eines der zwei Substrate mit einer dielektrischen Oberflächenschicht auf der Seite seiner Hauptfläche versehen ist, das Verfahren umfassend die folgenden Schritte:
(a) das Inkontaktbringen der Hauptflächen der zwei Substrate, dann;
(b) das Initiieren und das Ausbreiten eines Bindungswelle zwischen den Hauptflächen der zwei Substrate, um diese miteinander zusammenzufügen;
wobei das Verfahren **dadurch gekennzeichnet ist, dass** es vor dem Schritt des Inkontaktbringens einen Schritt der Herstellung der dielektrischen Oberflächenschicht umfasst, der darauf gerichtet ist, in diese Schicht eine Schwefeldosis, die größer als 3,0 E13 at/cm^2 ist, einzubringen.

2. Verfahren zum Zusammenfügen nach dem vorstehenden Anspruch, wobei die Schwefeldosis größer als 3,5 E13 at/cm^2 ist.

3. Verfahren zum Zusammenfügen nach einem der vorstehenden Ansprüche, wobei der Schritt der Herstellung der dielektrischen Oberflächenschicht auch darauf gerichtet ist, in diese Schicht eine Fluordosis, die größer als 4,0 E14 at/cm^2 ist, einzubringen.

4. Verfahren zum Zusammenfügen nach einem der Ansprüche 1 und 2, wobei der Schritt der Herstellung die Aktivierung der dielektrischen Oberflächenschicht durch ein Plasma eines Gases umfasst, umfassend Schwefel, wie ein Plasma, umfassend das Schwefelhexafluorid.

5. Verfahren zum Zusammenfügen nach dem vorstehenden Anspruch, wobei das Plasma auch Sauerstoff oder Stickstoff umfasst.

6. Verfahren zum Zusammenfügen nach dem vorstehenden Anspruch, wobei die Aktivierung der dielektrischen Oberflächenschicht während einer Aktivierungsdauer zwischen 15 Sekunden und 2 Minuten durchgeführt wird.

7. Verfahren zum Zusammenfügen nach dem vorstehenden Anspruch, wobei die Oberflächenschicht dem Sauerstoff- oder Stickstoffplasma während der gesamten Dauer der Aktivierung ausgesetzt wird, und eine kontrollierte Menge an Schwefelhexafluorid dem Sauerstoff oder dem Stickstoff während einer bestimmten Periode der Aktivierungsdauer beigemischt wird.

8. Verfahren zum Zusammenfügen nach dem vorstehenden Anspruch, wobei der bestimmten Periode jeweils Perioden vorausgehen und folgen, während denen die dielektrische Oberflächenschicht dem Plasma, das aus einem Aktivierungsgas aus Sauerstoff oder Stickstoff ausgebildet wird, ausgesetzt wird.

9. Verfahren zum Zusammenfügen nach einem der Ansprüche 1 bis 2, wobei der Schritt der Herstellung die Herstellung einer Kammer einer Plasmaaktivierungsausrüstung durch ein Plasma eines Gases umfasst, umfassend Schwefel, dann, wobei nach der Herstellung der Kammer, die Behandlung der dielektrischen Oberflächenschicht in der Kammer durch ein Plasma Sauerstoff oder Stickstoff umfasst.

10. Verfahren zum Zusammenfügen nach einem der vorstehenden Ansprüche, umfassend die Wärmebehandlung der zwei miteinander zusammengefügten Substrate.

11. Verfahren zum Zusammenfügen nach einem der vorstehenden Ansprüche, wobei die zwei Substrate mit einer dielektrischen Oberflächenschicht aus Siliciumoxid oder Siliciumnitrid auf der Seite ihrer Hauptfläche versehen sind, und der Schritt der Herstellung an jeder der dielektrischen Oberflächenschichten durchgeführt wird.

12. Verfahren nach einem der vorstehenden Ansprüche, wobei die dielektrische Oberflächenschicht aus Siliciumoxid besteht.

13. Verfahren zum Zusammenfügen nach einem der vorstehenden Ansprüche, umfassend einen Schritt des Reinigens mindestens einer der Hauptflächen der zwei Substrate zwischen dem Schritt der Herstellung und dem Schritt des Inkontaktbringens.

14. Struktur (1), umfassend ein Trägersubstrat (2), eine vergrabene dielektrische Schicht (3), die auf dem Trägersubstrat (2) angeordnet und mit diesem in Kontakt ist, und eine Schicht, genannt "Nutzschicht" (4) auf der vergrabenen Schicht (3) und mit dieser in Kontakt, wobei die Struktur **dadurch gekennzeichnet ist, dass** die vergrabene dielektrische Schicht (3) eine Schwefeldosis, die größer als 3,0 E13 at/cm^2 ist, vorweist.

15. Struktur (1) nach dem vorstehenden Anspruch, wobei die Schwefeldosis größer als 3,5 E13 at/cm^2 ist.

16. Struktur (1) nach dem vorstehenden Anspruch, wobei die vergrabene dielektrische Schicht (3) eine Fluordosis, die größer als 4,0 E14 at/cm^2 ist, vorweist.

17. Struktur (1) nach einem der Ansprüche 14 bis 16, wobei die vergrabene dielektrische Schicht aus Siliciumoxid besteht.

## Claims

1. Method for assembling by molecular adhesion two substrates each having a main face, at least one of the two substrates being provided with a surface dielectric layer on the main face thereof, the method comprising the following steps:
(a) bringing the main faces of the two substrates into contact, then;
(b) initiating and propagating a bonding wave between the main faces of the two substrates in order to assemble them together;
the method being **characterized in that** it comprises, prior to the contacting step, a step of preparing the surface dielectric layer for the purpose of introducing a sulfur dose greater than 3.0 E13 at/cm² into this layer.

2. Assembly method according to the preceding claim, wherein the sulfur dose is greater than 3.5 E13 at/cm².

3. Assembly method according to either of the preceding claims, wherein the step of preparing the surface dielectric layer also has the purpose of introducing a fluorine dose greater than 4.0 E14 at/cm² into this layer.

4. Assembly method according to either claim 1 or claim 2, wherein the preparation step comprises activating the surface dielectric layer by a plasma of a gas comprising sulfur, such as a plasma comprising sulfur hexafluoride.

5. Assembly method according to the preceding claim, wherein the plasma also comprises oxygen or nitrogen.

6. Assembly method according to the preceding claim, wherein the activation of the surface dielectric layer is carried out for an activation time of between 15 seconds and 2 minutes.

7. Assembly method according to the preceding claim, wherein the surface layer is exposed to the oxygen or nitrogen plasma for the duration of the activation, and a controlled quantity of sulfur hexafluoride is mixed with the oxygen or nitrogen for a determined period of the activation time.

8. Assembly method according to the preceding claim, wherein the determined period is respectively preceded and followed by periods during which the surface dielectric layer is exposed to the plasma formed by an activation gas of oxygen or nitrogen.

9. Assembly method according to either claim 1 or claim 2, wherein the preparation step comprises preparing a chamber of a plasma activation apparatus by a plasma of a gas comprising sulfur and then, after preparing the chamber, treating the surface dielectric layer in the chamber by a plasma comprising oxygen or nitrogen.

10. Assembly method according to any of the preceding claims comprising heat treatment of the two substrates assembled together.

11. Assembly method according to any of the preceding claims, wherein the two substrates are provided with a surface dielectric layer of silicon oxide or silicon nitride on the main face side thereof, and the preparation step is carried out on each of the surface dielectric layers.

12. Assembly method according to any of the preceding claims, wherein the surface dielectric layer is made of silicon oxide.

13. Assembly method according to any of the preceding claims comprising a step of cleaning at least one of the main faces of the two substrates, between the preparation step and the contacting step.

14. Structure (1) comprising a support substrate (2), a buried dielectric layer (3) arranged on and in contact with the support substrate (2) and a so-called "useful" layer (4) on and in contact with the buried layer (3), the structure being **characterized in that** the buried dielectric layer (3) has a sulfur dose greater than 3.0 E13 at/cm².

15. Structure (1) according to the preceding claim, wherein the sulfur dose is greater than 3.5 E13 at/cm².

16. Structure (1) according to the preceding claim, wherein the buried dielectric layer (3) comprises a fluorine dose greater than 4.0 E14 at/cm².

17. Structure (1) according to any of claims 14 to 16, wherein the buried dielectric layer is made of silicon oxide.
